# EUROPEAN PATENT APPLICATION

(11) **EP 3 506 345 A1**
(43) Date of publication of application: **03.07.2019**
(21) Application number: 18212671.4
(22) Date of filing: 14.12.2018
(51) Int. Cl.: H01L 23/42, H05K 7/20

(54) **THERMALLY CONDUCTIVE MEMBER**

(30) Priority: 26.12.2017 KR 20170179617; 23.05.2018 KR 20180058656
(71) Applicant: Joinset Co., Ltd, Ansan-si, Gyeonggi-do 15613 (KR)
(72) Inventor: KIM, Sun-Ki, 15823 Gunpo-si, Gyeonggi-do (KR); KIM, Sung-Hoon, 15613 Ansan-si, Gyeonggi-do (KR); LEE, Hyun-Ill, 15613 Ansan-si, Gyeonggi-do (KR); LEE, Seong-Jin, 15613 Ansan-si, Gyeonggi-do (KR); KIM, Jin-San, 15613 Ansan-si, Gyeonggi-do (KR)
(74) Representative: Kuhnen & Wacker Patent- und Rechtsanwaltsbüro PartG mbB

(57) **Abstract**

Disclosed is a thermally conductive member capable of reliably performing a thermally conductive function with a simple structure. The thermally conductive member includes a container including an elastic body with a through hole passing through a top surface and a bottom surface thereof in a thickness direction and a thermally conductive support adhering to the bottom surface of the body and a thermally conductive element inserted or filled in an accommodation space formed by the through hole and the support and having self adhesion.

## Description

### CROSS-REFERENCE TO RELATED APPLICATION

This application claims priority to and the benefit of Korean Patent Application No. 2017-0179617, filed on December 26, 2017 and 2018-0058656, filed on May 23, 2018, the disclosure of which are incorporated herein by reference in its entirety.

### BACKGROUND

### 1. Field of the Invention

The present invention relates to a thermally conductive member.

### 2. Discussion of Related Art

As electronic communication devices including cellular phones have been advanced and highly functional, a processing speed of a microprocessor increases such that electromagnetic waves and heating rear up as big problems.

To solve the problems, for example, a cooling unit is generally used for discharging heat generated by a microprocessor to the outside.

A heat dissipation unit is used while being interposed between, for example, a case for cooling and an electronic component mounted on a circuit board. For example, one surface of a thermal interface materials (TIM) having flexibility and partial elasticity is attached to a heating source such as a microprocessor mounted on a circuit board and the other surface thereof is attached to a case such that heat generated by the heating source is transferred to the case through the TIM and cooled and scattered by the case.

Korean Patent Registration No. 0820902, filed by the present applicant, discloses a multilayer thermally conductive pad including a thermally conductive elastic body having a certain volume, a thermally conductive elastic adhesive surrounding an outside of the thermal conductive elastic body and adhering thereto through curing, and a polymer film surrounding the outside of the thermally conductive elastic adhesive and adhering thereto through the curing and having a rear surface to which a metal foil is joined.

Also, Korean Patent Registration No. 1228603 discloses a thermally conductive elastic gasket including a sponge which is an internal elastic body, a thermally conductive layer formed on an outer surface of the sponge and including a graphite layer embedded between base films, and an adhesive layer fixing the sponge to the thermally conductive layer. Here, in the thermally conductive layer, each of the base films attached to both sides of the graphite layer or the base film attached to an outer surface of the graphite layer is formed to be larger than the graphite layer such that the base films directly are laminated directly to each other not to allow the graphite layer to be exposed outward.

According to the patents, since the polymer film or the base films surround the thermally conductive elastic body or the sponge, respectively, elasticity of the elastic body or the sponge is limited not to adequately use elasticity and the elastic body or the sponge may not be adequately surrounded or much time and cost are necessary to surround them when the elastic body or the sponge is manufactured while having a variety of shapes.

Also, since the metal layer or the graphite layer is formed the polymer film or the base film above the elastic body or the sponge, when being repeatedly pressed by a force applied in a vertical direction and being much pressed, a side surface of the metal layer or the graphite layer without elasticity is distorted or broken.

Also, the polymer film or the base film includes an unrestorable material and is easily deformed by an external push.

Also, being applied to an earphone including a voice coil oscillating due to an electrical signal, when the polymer film or the base film having a smooth surface and high mechanical strength comes into direct contact with a heating source or an object to be cooled, it is easy to slide or move due to repeated micro oscillation such that acoustic noise may occur.

Korean Patent Registration No. 1715988, filed by Dexerials Corp, Japan, discloses a thermally conductive support and a method of manufacturing the same. The method includes at least an extrusion molding operation of extruding a thermally conductive compound having a polymer, an anisotropic thermally conductive filer, and a filler and molding an extruded mold in which the anisotropic thermally conductive filer is aligned along an extrusion direction, a curing operation of curing the extruded mold to form a cured material, and a cutting operation of cutting the cured material into pieces of having a certain thickness in a direction perpendicular to the extrusion direction by using an ultrasonic cutter.

Since gas pockets are not formed therein, the thermally conductive support according to the patent lacks elasticity and restorability. Since the polymer is mixed with a large amount of the filler to increase thermal conductivity, due to low self adhesion and being cut in the direction perpendicular to the extrusion direction, it is difficult to economically continuously manufacture the thermally conductive support.

Also, since the filler has a length relatively longer than a diameter, the filler is exposed outward at a section thereof such that a surface of the thermally conductive support is coarse. Also, the filler is carbon fiber which is slithery.

Also, due to low mechanical strength, the filler is easily damaged while being manufactured, delivered, and processed such that it is difficult to handle and process the filler.

Also, according to another conventional technology, there is present an electrically insulated thermally conductive support manufactured by uniformly mixing an elastic silicone rubber with thermally conductive powder such as alumina powder, casting, curing and then cutting the cured material into pieces having a certain length.

According to the technology, since the thermally conductive support does not gas pockets, the thermally conductive support lacks elasticity and restorability and has a short elastically operational distance.

Also, when hardness of the thermally conductive support is decreased to easily come into contact with an object with less force, mechanical strength of the thermally conductive support is low and easily damaged while being manufactured, delivered, and processed such that handling and processing thereof are difficult.

### SUMMARY OF THE INVENTION

The present invention is directed to providing a thermally conductive member capable of efficiently and reliably performing a thermally conductive function using a simple structure.

The present invention is also directed to providing a thermally conductive member which is integrated and has high elasticity and restorability and excellent thermally conductive function.

The present invention is also directed to providing a thermally conductive member which has high mechanical strength, low hardness, and a long operational distance.

The present invention is also directed to providing a thermally conductive member which needs less pressing force overall and has high restorability and excellent thermally conductive function.

The present invention is also directed to providing a thermally conductive member which easily performs elasticity and restorability of an elastic body and increases a restoration rate of a thermally conductive element.

The present invention is also directed to providing a thermally conductive member which includes a smooth surface having a high frictional coefficient so as to maximize heat transfer with an object in contact therewith and to minimize noise or movement caused by vibration or friction.

The present invention is also directed to providing a thermally conductive member capable of completely absorbing vibrations and shocks transferred from an object.

The present invention is also directed to providing a thermally conductive member capable of reliably transferring heat generated by an electronic component to a metal case through a shortest distance.

The present invention is also directed to providing a thermally conductive member easily manufactured with a precise size.

The present invention is also directed to providing a thermally conductive member capable of shielding electromagnetic waves.

The present invention is also directed to providing a thermally conductive member easily manufactured and provided with a precise size.

The present invention is also directed to providing a thermally conductive member which is formed of a single body to be easily mounted or demounted.

According to one aspect of the present invention, a thermally conductive member interposed between objects facing each other to transfer heat in a vertical direction. The thermally conductive member includes a container including an elastic body including a through hole passing through a top surface and a bottom surface thereof in a thickness direction and a thermally conductive support adhering to the bottom surface of the body and a thermally conductive element inserted or filled in an accommodation space formed by the through hole and the support and having self adhesion. Here, the thermally conductive element and the thermally conductive support come into contact with the objects.

According to another aspect of the present invention, a thermally conductive member interposed between objects facing each other and including a heating source and a cooling unit to transfer heat in a vertical direction. The thermally conductive member includes a container including an annular elastic body having a uniform thickness and a determined width and a thermally conductive support adhering to a bottom surface of the body and a thermally conductive element having viscosity and accommodated in an accommodation space of the container and adhering to the support. Here, thermally conductive element, due to spreadabilty caused by the viscosity thereof, horizontally spreads in the accommodation space due to a force applied to thermally conductive element in a vertical direction.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG. 1A illustrates a thermally conductive member according to one embodiment of the present invention, and FIG. 1B is a cross-sectional view taken along a line b-b;
FIGS. 2A to 2C illustrate thermally conductive supports having a variety of structures;
FIGS. 3A to 3C are a perspective view, a top view, and a cross-sectional view illustrating thermally conductive members according to other embodiments of the present invention, respectively;
FIG. 4 illustrates a modified example of a body capable of being applied to the embodiment; and
FIGS. 5A to 5C illustrate a process of manufacturing a thermally conductive member according to the embodiment.
FIG. 6 illustrates a thermally conductive member according to another embodiment.

### DETAILED DESCRIPTION OF EXEMPLARY EMBODIMENTS

Hereinafter, the present invention will be described in detail with reference to the attached drawings.

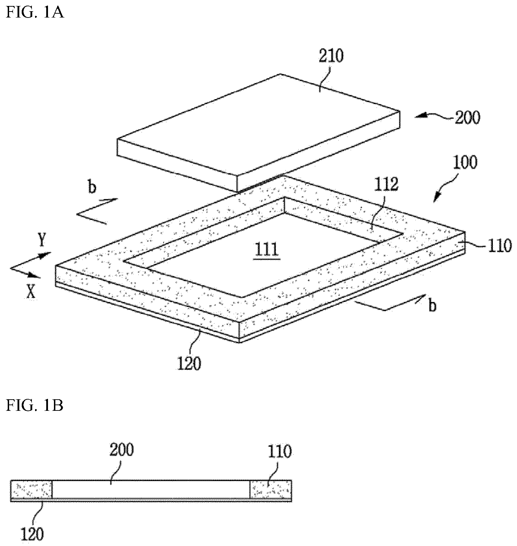

FIG. 1A illustrates a thermally conductive member according to one embodiment of the present invention, and FIG. 1B is a cross-sectional view taken along a line b-b.

The thermally conductive member includes a body 110 with a through hole 112, a thermally conductive support 120 bonded to a bottom surface of the body 110, a thermally conductive element 200 inserted into and combined with the through hole 112.

The body 110 forms a container 100 with the support 120, which adheres to the bottom surface thereof, and accommodates the thermally conductive element 200 in an accommodation space 111 in the container 100.

Hereinafter, a structure and a function of each of components will be described.

### 1. Body 110

The body 110 is a foaming body which has pores to have high elasticity and restoring force and a great elastically-operational distance and to be easily pushed with less force and may be one of thermoplastic urethane sponge and polyethylene sponge which are melted by heat and thermosetting silicone sponge. For example, the body 110 may be one kind of Poron that is a brand name of products of Rogers Corp. in USA.

The body 110 helps the thermally conductive element 200 in coming into elastic contact with a heating source or a cooling metal and has density lower than density of the thermally conductive element 200 such that the thermally conductive element 200 is well pushed by a less external force.

An outer surface of the body 110 includes a skin layer formed during a process of forming a foaming body to have a smooth surface so as to come into close contact with a facing object, to well absorb vibration and shock, and to well adhere to the thermally conductive support 120.

The body 110 has low thermal conductivity and is not used as a thermally conductive medium but has high elasticity and a high restoration rate such that the thermally conductive element 200 comes into reliable contact with a heating source and a cooling unit, vibration or shock is easily absorbed, a pushing force is less needed overall.

The body 110 includes flat top and bottom surfaces and the through hole 112 formed passing through the top and bottom surfaces. The through hole 112 is formed by a cutting-edge mold to be perpendicular to the top and bottom surfaces and may have a quadrangular shape in the embodiment or may have a circular shape as described below.

A thickness of the body 110 is not particularly limited and may be about 0.2 mm to 4 mm. When the thickness is too small, mechanical strength is low. When the thickness is too great, due to manufacturing costs of the thermally conductive element 200 having high viscosity, it may be more effective to use a metal spring or to detect another alternative.

### 2. Thermally Conductive Support 120

The thermally conductive support 120 adheres to the bottom surface of the body 110 and blocks the bottom surface of the body 110 to form the container 100 with the body 110 so as to fill the container 100 with the thermally conductive element 200 and to self-adhere to or come into contact with an object such as the cooling unit.

The support 120 is formed by equally mixing a silicone rubber or acrylic resin with thermally conductive powder or thermally conductive fibers.

The support 120 has a sheet shape and a thickness of, for example, 0.05 mm to 0.2 mm smaller than a thickness of the thermally conductive element 200. Generally, when the thickness is great, mechanical strength is high.

Both sides of the support 120 have self adhesion such that one surface self-adheres to the bottom surface of the body 110 and blocks the through hole 112 of the body 110 to form the container 100 and the other surface adheres an object, for example, the cooling unit.

The support 120 and the thermally conductive element 200 have equal or similar polymer material based so as to excellent adhesion therebetween.

The thermal conductivity of the support 120 is 0.5 W to 3 W lower than thermal conductivity of the thermally conductive element 200. However, it is possible to minimize a decrease in heat transfer by minimizing the thickness of the support 120.

Since the support 120 has the same size as that of the body 110, for example, the support 120 may adhere to the cooling unit and the thermally conductive element 200 may adhere to the heating source. Here, the thermally conductive element 200 having a small size intensively absorbs heat generated by the heating source and transfers the heat to the support 120 having a large size so as to quickly perform heat transfer.

Together with this, when the support 120 is attached to a metal case which is a cooling unit and then a printed circuit board, on which a semiconductor chip is mounted, and a case are assembled, since the thermally conductive element 200 automatically comes into contact with the semiconductor chip, an assembling operation is easy and simple. Also, the thermally conductive element 200 having a small size and low self adhesion is easily separated from the semiconductor chip such that reworking and recycling are easy.

Including the embodiment, the support 120 may have a variety of structures.

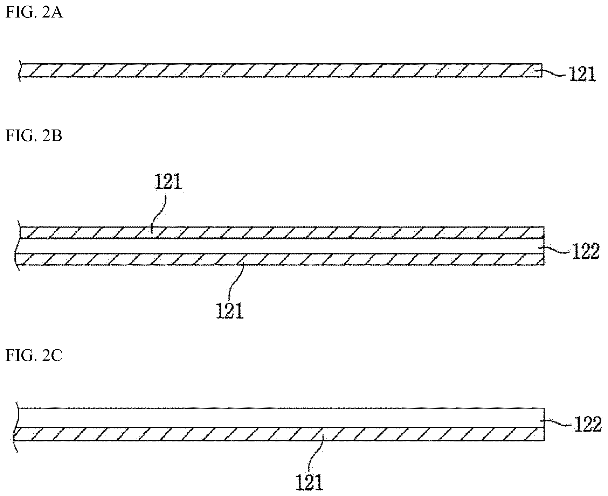

FIGS. 2A to 2C illustrate thermally conductive supports having a variety of structures.

In FIG. 2A, like the embodiment, the support includes a thermally conductive adhesive sheet 121 which is a single body including thermally conductive powder uniformly mixed with a silicone rubber or an acrylic resin and has self adhesion on both sides.

Since the thermally conductive adhesive sheet 121 does not include a base material such as a polyethylene terephthalate (PET) film, the thermally conductive adhesive sheet 121 has low mechanical strength but has high flexibility and does not crumple easily.

The thermally conductive adhesive sheet 121 may be used when an adhesive is not present on the bottom surface of the body 110 and may be manufactured by casting and then curing a liquid thermally conductive silicone rubber or acrylic resin mixed with a thermally conductive powder.

FIG. 2B illustrates a structure in which the thermally conductive adhesive sheets 121 are formed on both sides of a thermally conductive base material 122, and FIG. 2C illustrates a structure in which the thermally conductive adhesive sheet 121 is formed on one surface of the thermally conductive base material 122. Here, the base material 122 may be a metal foil such as a copper foil and an aluminum foil, a graphite sheet to which a protective film adheres, or fiber coated with a metal layer.

The thermally conductive adhesive sheet 121 may be manufactured by casting and curing a liquid thermally conductive silicone rubber or acrylic resin mixed with thermally conductive powder to the thermally conductive base material 122.

Particularly, as shown in FIG. 2C, when the thermally conductive element 200 comes into direct contact with the thermally conductive base material 122 having high thermal conductivity and a smooth surface and formed of copper or aluminum, heat may be easily transferred to the thermally conductive element 200 and the thermally conductive element 200 may easily spread and adhere.

Including the same structure, a thermally conductive elastic coating layer such as a silicone or rubber may be applied instead of the thermally conductive adhesive sheet 121 and may not have self adhesion which will be described below.

### 3. Thermally Conductive Element 200

As the thermally conductive element 200, for example, a flexible silicone rubber or acrylic resin-based thermally conductive rubber, resin, gel, and clad may be applied. Otherwise, when a thermally conductive member is very thin, a graphite sheet may be applied.

Thermal conductivity of the thermally conductive element 200 is greater five times than thermal conductivity of the body 110. For example, the heat conductivity of the thermally conductive element 200 may be about 1 W to 30 W. One body 110 may include a plurality of such through holes 112 such that a plurality of such thermally conductive elements 200 may be applied.

The thermally conductive element 200 may be provided with a variety of hardness values depending on use thereof. As an example, the hardness of the thermally conductive element 200 may be equal to or smaller than Shore A 70. The thermally conductive element 200 may be a clad having low elasticity and low hardness or may be a gel when being used for a particular use. For example, the thermally conductive element 200 may be one kind of thermal materials of US Laird technology.

A top surface and a bottom surface of the thermally conductive element 200 may have self adhesion, or at least a surface which comes into contact with the heating source may have self adhesion.

The thermally conductive element 200 may include electrical insulation or electrical (semi) conductivity. When the thermally conductive element 200 is manufactured by mixing a polymer resin or rubber with thermally conductive powder such as alumina powder, the thermally conductive element 200 may include electrical insulation. When the thermally conductive element 200 is manufactured by mixing with high thermally conductive carbon fiber and the like or formed of a graphite sheet, the thermally conductive element 200 is electrically (semi) conductive.

Generally, when carbon powder is mixed or a graphite sheet is applied, thermal conductivity is higher than a case of mixing ceramic powder. In this case, one surface of the thermally conductive element 200 is coated thinly with an electrically insulated thermally conductive silicone to have electrical insulation such that the one surface comes into contact with the cooling unit to maintain electrical insulation between the heating source and the cooling unit and to easily perform heat transfer.

Since the thermally conductive element 200 is flexible and has higher density and hardness than those of the body 110, the thermally conductive element 200 easily comes into close contact with the heating source and the cooling unit due to an external pressure such that heat generated by the heating source is efficiently and easily transferred to the cooling unit through the thermally conductive element 200.

Since the top surface and the bottom surface of the thermally conductive element 200 are level with each other such that the thermally conductive element 200 has a uniform thickness, the top surface of the thermally conductive element 200 may protrude, be level, or be located further inside on the basis of an inlet of the through hole 112.

As described above, a top surface of the support 120 has self adhesion or is coated with an adhesive and the bottom surface of the thermally conductive element 200 has self adhesion such that the thermally conductive element 200 adheres and is fixed to the top surface of the support 120.

With this, when a side surface of the thermally conductive element 200 has self adhesion, the thermally conductive element 200 spontaneously adheres to a side surface of the through hole 112 such that more reliable adhesion may be provided.

According to the thermally conductive member of the embodiment, the body 110 and the thermally conductive element 200 are mechanically integrated such that the thermally conductive element 200 may be prevented from vertically moving in or deviating from the through hole 112 due to externally applied vibrations or shocks. The body 110 and the thermally conductive element 200 integrally receive and easily absorb external vibrations or shocks.

Also, since the body 110 is strongly integrated with the thermally conductive element 200 such that the thermally conductive element 200 may not be easily separated from the body 110 by an external force and may be mounted on or separated from an object at once to reduce manufacturing costs.

Also, since the thermally conductive element 200 having relatively low elasticity and restorability is integrated with the container 100 including the body 110 having high elasticity and restorability, when a thermally conductive member is smoothed after being pressed, the body 110 returns to an original position due to restorability such that the thermally conductive element 200 integrated therewith may also be restored partially according to a height.

In the thermally conductive element 200, at least the top surface has self adhesion to be easily mounted on a facing object. A surface of the thermally conductive element 200 which faces the heating source may have self adhesion and an opposite surface does not have self adhesion such that the thermally conductive element 200 may be easily vacuum-picked up and handled.

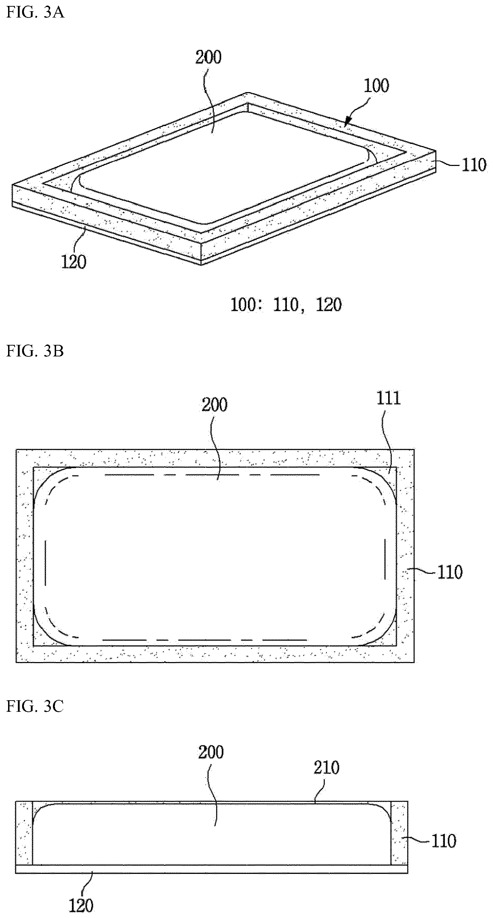

FIGS. 3A to 3C are a perspective view, a top view, and a cross-sectional view illustrating thermally conductive members according to other embodiments of the present invention, respectively.

Hereinafter, for convenience of description, only components different from those of the one embodiment will be described.

The thermally conductive element 200 may be any one of a silicone rubber or acrylic resin uniformly mixed with thermally conductive powder or fiber having self adhesion and may include viscosity and flowability and spreadability according to the viscosity so as to spread or flow due to a vertically applied external force or a rotating force on a horizontal surface.

In the embodiment, the thermally conductive element 200 is in a paste, clay, or putty state at a high viscosity level or may be a paste or grease state at an intermediate viscosity level.

Here, viscosity refers to stickiness (a sticky or gluey property of a material) included in a fluid, that is, is a qualitative expression which refers to a partially sticky property of fluid elements or internal resistance of a fluid resisting fluidal movement. The viscosity level (a viscosity index, a viscosity coefficient, and the like) is a qualitative expression which refers to a degree of resisting against a fluid. Generally, when a fluid has higher viscosity, a viscosity level and resistance level are higher.

In the embodiment, when viscosity of a general toothpaste is defined as an intermediate viscosity level, "a high viscosity level" refers to a viscosity level higher than that of the toothpaste and approximately means a state in which an original shape is maintained without flowing down when being ejected onto a flat surface by an injector and level at room temperature but a material may spread in a variety of directions including a horizontal direction when being pressed with a small force in a vertical direction.

Since it is difficult to represent the definition of the high viscosity level, for example, in the case of a dispensable gap filler of US Laird tech. (www.lairdtech.com) whose trade name is Tputty 508, instead of a viscosity level, a flow rate may be represented, for example, the flow rate is 50 g/min at 75 cc taper tip, 0.125" orifice, and 40 psi.

In the embodiment, "the intermediate viscosity level" may be defined as a viscosity level, lower than the high viscosity level, at which "a material maintains a slightly flowing down shape when being ejected onto a flat surface by an injector and level at room temperature but easily spreads in a variety of directions including a horizontal direction when being pressed with a small force in a vertical direction. Also, the viscosity level, lower than the high viscosity level, may mean from about 1,500,000 cps.

The thermally conductive element 200 includes viscosity at a high viscosity level or intermediate viscosity level and includes flowability and spreadability according thereto and has a property of being hardly separated after adhering to the support 120 unless an external force is applied.

The thermally conductive element 200 includes flowability and self adhesion according to viscosity thereof so as to self-adhere to an object which comes into contact therewith. In other words, the thermally conductive element 200 may have self adhesion of being sticky due to viscosity of an acrylic resin or silicone rubber which forms the thermally conductive element 200.

As described above, the top surface of the thermally conductive element 200 has self adhesion. In this case, since a problem of sticking to another object while being handled or delivered is present, a thermally conductive member may be provided while being covered with a plastic protection cover.

In order to allow thermally conductive powder included in the thermally conductive element 200 to enter gas pockets in an inner surface of the through hole 112 of the body 110, the thermally conductive powder may have a size smaller than a diameter of the gas pocket.

Since a top surface 210 of the thermally conductive element 200 is level and has an equal or similar thickness when the thermally conductive element 200 is pressed, in order to efficiently transfer heat, the top surface of the thermally conductive element 200 may be level with or be slightly lower than the top surface of the body 110 and may be adequately adjusted according to viscosity, a viscosity level, and an area of the thermally conductive element 200.

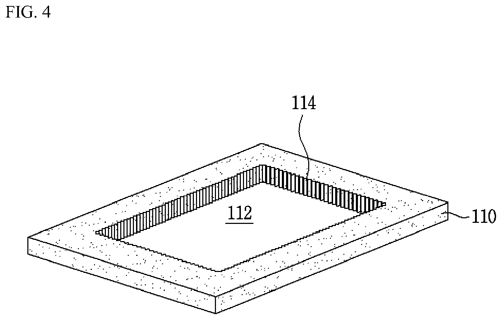

FIG. 4 illustrates a modified example of a body capable of being applied to the embodiment.

According to the embodiment, uneven portion 114 is formed along an inner wall of the through hole 112 of the body 110 in a thickness direction.

A size of the uneven portion 114 is not particularly limited. When the thermally conductive element 200 is filled or inserted into through hole 112, the uneven portion 114 may be completely or partially filed with the thermally conductive element 200 due to the viscosity and spreadability of the thermally conductive element 200.

In this state, when being pressed by an object, the thermally conductive element 200 decreases in a height and laterally spreads. Here, before or at the same time as the body 110 having higher elasticity also laterally spreads due to the thermally conductive element 200, the uneven portion 114 is filled with a part of the thermally conductive element 200 such that the uneven portion 114 partially accommodates spreading of the thermally conductive element 200.

Particularly, when the through hole 112 is filled with the thermally conductive element 200, a part of the uneven portion 114 may not be filled with the thermally conductive element 200 and may have an empty space such that the empty space is filed with a part of the thermally conductive element 200 when the thermally conductive element 200 is pressed by a pressure of an object.

Also, the thermally conductive support 120 may include one or more discharge holes. When the part of the thermally conductive element 200 ejected into the accommodation space 111 of the body 110 is pressurized, the part of the thermally conductive element 200 deviates outward through the discharge holes such that the thermally conductive element 200 deviating outward may come into direct contact with the heating source or the cooling unit so as to efficiently perform heat transfer.

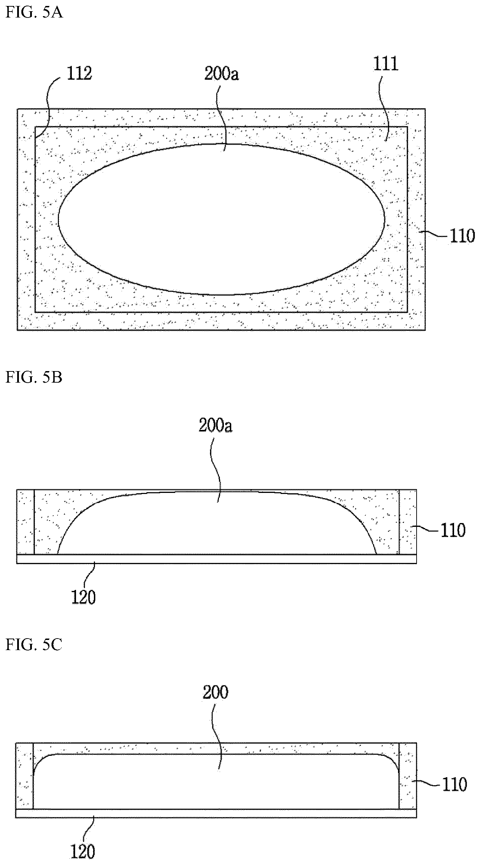

FIGS. 5A to 5C illustrate a process of manufacturing a thermally conductive member according to the embodiment.

Referring to FIG. 5A, the thermally conductive element 200a is ejected using a dispenser and the like into the through hole 112 of the body 110 and the accommodation space 111 in the body 110 formed by the thermally conductive support 120.

Although an ejection amount of the thermally conductive element 200a is not specified, it may be determined in consideration of a volume of the accommodation space 111 of the body 110 and a position of the thermally conductive element 200 filled in a thermally conductive member finally manufactured.

For example, since a thermally conductive element 200a is used while being pressed, a total volume of the thermally conductive element 200a may be smaller than a total volume of the accommodation space 111 and the ejected thermally conductive element 200a may have a height not to protrude from the top surface of the body 110.

Accordingly, like the above example, the ejection amount may be provided to allow the ejected thermally conductive element 200a not to come into contact with an inner surface of the body 110 and not to protrude from the body 110.

Not limited thereto, the thermally conductive element 200a may be ejected as much as an amount to come into contact with the inner surface of the body 110 or to protrude from the body 110.

The ejected thermally conductive element 200a may be provided to have an equal or similar shape in a lateral direction and a vertical direction on the basis of a center of the body 110.

The ejected thermally conductive element 200a having a shape like the embodiment may be interposed and spread between objects and come into contact with the inner surface of the body 110.

While the thermally conductive element 200a is ejected in a state shown in FIGS. 5A and 5B, the thermally conductive element 200a adheres to the thermally conductive support 120 due to self adhesion of the thermally conductive element 200a.

As described above, the thermally conductive element 200a having self adhesion and viscosity and flowability and spreadability according thereto is ejected into the accommodation space 111 in the body 110 which functions as a container and self-adheres to the thermally conductive support 120 so as to manufacture a thermally conductive member which is a single body.

Meanwhile, selectively, as shown in FIG. 5C, a process of filling the accommodation space 111 in the body 110 with the thermally conductive element 200a to allow the thermally conductive element 200a to come into the inner wall of the accommodation space 111 may be performed.

In detail, when the thermally conductive element 200a is ejected as shown in FIG. 5C, a force is applied to the ejected thermally conductive element 200a in a vertical direction, or the body 110 is rotated, the thermally conductive element 200a having viscosity is allowed to spread or flow due to flowability thereof in a horizontal direction in the accommodation space 111 of the body 110.

Here, the thermally conductive element 200 may not come into contact with the inner wall of the accommodation space 111 of the body 110. Even in contact therebetween, particularly, when the ejected thermally conductive element 200a has an original shape, empty spaces may be formed at four corners of the accommodation space 111 of the body 110.

When the thermally conductive member is used while being interposed between the objects, the empty space functions as a buffer space for accommodating the thermally conductive element 200a which spreads horizontally when being pressed by the objects.

In the embodiment, the thermally conductive element 200 may have a variety of shapes according to the thermally conductive element 200a ejected from the dispenser and is not limited to a circular shape, an oval shape, or an oblong shape shown in the embodiment and may have an irregular shape. In this state, the accommodation space 111 of the body 110 may be filled or be partially filled with the thermally conductive element 200a pressed by the object.

As described above, a shape and an amount of the thermally conductive element 200 may be adequately provided according to a gap tolerance between objects and shapes thereof.

The thermally conductive member having the same structure is used while being interposed between the heating element such as an integrated circuit (IC) or semiconductor chip and the cooling unit such as a metal case. When the object is pressed, the body 110 and the thermally conductive element 200 are also pressed such that the thermally conductive support 120 may come into contact with a surface of the cooling unit and the thermally conductive element 200 may come into contact with a surface of the heating element.

Here, it is possible to efficiently select to attach the thermally conductive member first to the metal case and then assembled with the semiconductor chip or first to the semiconductor chip and then assembled with the metal case. For example, the thermally conductive support 120 wider than an exposed surface of the thermally conductive element 200 is attached to the metal case which is the cooling unit and then a printed circuit board on which a semiconductor chip is mounted and a case are assembled such that a surface of the semiconductor chip comes into contact with the exposed surface of the thermally conductive element 200 to be easily and simply assembled.

In this structure, the thermally conductive element 200 having a small-sized exposed surface and low self adhesion is easily separated from the semiconductor chip such that reworking and recycling are easy. However, even when the self adhesion of the thermally conductive element 200 is low, since adhesion may increase according to a material of an object to which the thermally conductive element 200 adheres, it is necessary to note that it is impossible to adhere the thermally conductive element 200 to the heating element.

Also, since the thermally conductive element 200 is accommodated in the accommodation space 111 of the body 110 and the top surface thereof comes into contact with the object, when the thermally conductive element 200 is interposed between the objects and pressed, the thermally conductive element 200 spreads such that the thermally conductive element 200 easily performs its own thermally conductive function and the body 110 easily performs its own elastic restorability.

Also, the thermally conductive support 120 having mechanical strength is applied so as to reinforce mechanical strength of the body 110. That is, the body 110 is a foam body and has high restorability and flexibility but has low mechanical strength which is difficult to handle with. Here, the thermally conductive support 120 partially having mechanical strength is additionally adhered and applied so as to partially reinforce overall mechanical strength such that it is more easily to handle, mount, attach, and detach the body 110.

Also, the thermally conductive element 200 is ejected into the accommodation space of the body 110 and a force is applied in a vertical direction or the body 110 is rotated such that the thermally conductive element 200 spreads or flows. Here, the thermally conductive element 200 does not stick out of the body 110 such that a thermally conductive member having a uniform shape may be easily manufactured.

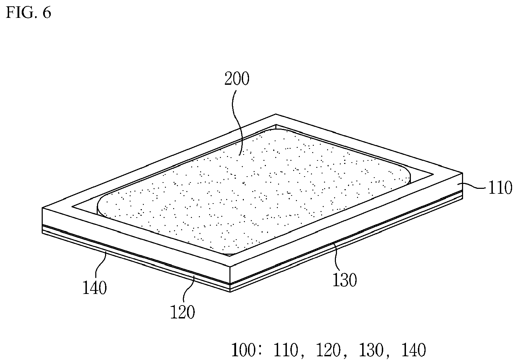

FIG. 6 illustrates a thermally conductive member according to another embodiment.

In the embodiment, the thermally conductive support 120 includes an aluminum foil or a copper foil and a thermally conductive elastic coating layer 140 is formed on at least a bottom surface thereof.

Since a top surface of the support 120 does not have self adhesion, the support 120 adheres to the body 110 due to an adhesive 130 adhering to the bottom surface of the body 110.

The coating layer 140 may be a thermally conductive silicone rubber coating layer and has an approximate solid phase and hardness which may be higher than that of the thermally conductive element 200 having a phase or putty phase.

As described above, although the coating layer 140 has hardness higher than that of the thermally conductive element 200 and has a less-flowable solid phase, when the coating layer 140 is pressed in a vertical direction, the thermally conductive element 200 having high flowability easily spreads in a horizontal direction so as to come into contact with a facing object.

As a result, the thermally conductive element 200 functions as a thermally conductive element having flowability and the coating layer 140 functions as a thermally conductive element without flowability so as to be mutually complementary to each other. Accordingly, an advantage of using the thermally conductive element 200 having a smaller thickness is present.

The coating layer 140 may be manufactured by thinly coating and curing, for example, an aluminum foil with a liquid thermally conductive silicone rubber. Here, a thickness of the aluminum foil may be 5 to 150 microns, and a thickness of the coating layer 140 may be 10 to 100 microns.

A bottom surface of the coating layer 140 may have self adhesion or may not have self adhesion.

When self adhesion is present, heat transfer is easier. When self adhesion is not present, it is easy to perform vacuum pickup from the surface.

According to this structure, since a thermally conductive member formed of sequentially stacking a thermally conductive element, a metal foil (aluminum foil), and a thermally conductive coating layer and having excellent thermal conductivity is in direct contact with a cooling unit and a heating source with elasticity, heat transfer is easily performed in a vertical direction.

Also, since the thermally conductive element 200 comes into direct contact with the thermally conductive support 120 due to self adhesion of the thermally conductive element 200 and the coating layer 140 having elasticity comes into direct and close contact with the heating source or the cooling unit, heat transfer is easily performed.

Also, overall mechanical strength is improved by a combination of the support 120 formed of a metal foil and the coating layer 140 such that handling is easily performed and mounting and demounting are easily performed.

In the embodiment, a product provided by combining the thermally conductive element 200 with the container 100 including the body 110 and the thermally conductive support 120 has been described as an example. According to circumstances, the container 100 including the body 110 and the thermally conductive support 120 is supplied as a product to a user and the user may squeeze the thermally conductive element 200 having viscosity and flowability and purchased additionally, for example, thermal grease, a thermal paste, or the like into the accommodation space 111 of the container 100 while the container 100 adheres to a semiconductor central processing unit (CPU), and then combine a cooling unit with the semiconductor CPU to use.

The thermally conductive member according to the present invention is interposed between objects such as a semiconductor chip, a speaker, a motor, a display panel, or the like which provides heat in an electronic device and a metal case, a heat sink, or the like which provides cooling, transfers heat, cools heat, and absorbs vibrations and shocks caused by the body being pressed when the thermally conductive element is pressed.

As described above, since the present invention is provided as a single body in which a thermally conductive support, a body having elasticity, and a thermally conductive element having a high viscosity level are combined to one another on a releasing film, there is provided an advantage of allowing a customer to economically use the thermally conductive element having a uniform shape and size and having a high viscosity level without using a dispenser, a printer, or the like in a workplace.

According to the above structure, a thermally conductive member capable of efficiently and reliably performing heat transfer using a simple structure may be provided.

Also, the thermally conductive member is formed by integrating a body having low harness, high elasticity and restorability, and a long operational distance with a thermally conductive element having hardness higher than that of the body and excellent thermally conductive function such that the thermally conductive member is easily mounted or demounted and the thermally conductive element has improved restorability due to the restorability of the body.

Also, since a side surface of the body is not covered and completely exposed outward, own elasticity and restorability of the body may be performed so as to completely absorb vibrations and shocks transferred from an object.

Also, the thermally conductive member including the thermally conductive element maintaining viscosity and flowability is provided as a single body, a customer may use the thermally conductive member without an ejection operation in a workplace.

Also, when thermally conductive element is pressed while being interposed between a heating source and a cooling unit, the thermally conductive element is not pressed exceeding a certain thickness due to a thickness of the body. As a result, the body provides a uniform distance between the heating source and the cooling unit such that the thermally conductive element easily has a uniform thickness and shape.

Also, since the thermally conductive element comes into direct contact with a thermally conductive support, which has high thermal conductivity and mechanical strength and is formed of a metal sheet having a smooth surface, due to self adhesion of the thermally conductive element, the thermally conductive element has high flowability, is not easily separated from the thermally conductive supports, and has excellent thermal conductivity.

Although the embodiments of the present invention have been described above, a variety of modifications may be made by those skilled in the art. Accordingly, the scope of the present invention will not be interpreted while being limited to the above embodiments but will be interpreted according to the following claims.

## Claims

1. A thermally conductive member interposed between objects facing each other to transfer heat between the objects, comprising:
a container comprising an elastic body including a through hole passing through a top surface and a bottom surface thereof in a thickness direction and a thermally conductive support adhering to the bottom surface of the body; and
a thermally conductive element inserted or filled in an accommodation space formed by the through hole and the support and having self adhesion,
wherein each of the thermally conductive element and the thermally conductive support comes into contact with the objects.

2. The thermally conductive member of claim 1, wherein the body is a foaming body formed of a urethane rubber or silicone rubber, and elastic restorability of the body is higher than elastic restorability of the thermally conductive element.

3. The thermally conductive element of claim 1, wherein the support adheres to the body due to an adhesive or adheres to the body due to self adhesion of the support.

4. The thermally conductive member of claim 1, wherein the thermally conductive element is formed in a phase state or a clay state.

5. The thermally conductive member of claim 1, wherein the thermally conductive support comprises one of:(a) a single thermally conductive adhesive sheet formed by uniformly mixing thermally conductive powder with a silicone rubber or acrylic resin; and(b) a stack body in which the thermally conductive adhesive sheet is formed on one or both surfaces of a thermally conductive base material.

6. A thermally conductive member interposed between objects facing each other including a heating source and a cooling unit to transfer heat between the objects, the thermally conductive member comprising:
a container comprising an annular elastic body having a uniform thickness and a determined width and a thermally conductive support adhering to a bottom surface of the body; and
a thermally conductive element having viscosity and accommodated in an accommodation space of the container and adhering to the support,
wherein the thermally conductive element, due to spreadabilty caused by the viscosity thereof, horizontally spreads in the accommodation space due to a force applied to the thermally conductive element in a vertical direction.

7. The thermally conductive member of claim 6, wherein the thermally conductive support and the body adhere to each other due to an adhesive.

8. The thermally conductive member of claim 6, wherein the thermally conductive element comprises self adhesion, and
wherein the thermally conductive element directly adheres to the support due to the self adhesion thereof.

9. The thermally conductive member of claim 8, wherein a bottom surface of the support has self adhesion, and
wherein the self adhesion of the thermally conductive element is lower than the self adhesion of the bottom surface of the support.

10. The thermally conductive member of claim 6, wherein the support comprises a thermally conductive base material formed of a metal foil such as an aluminum foil and a copper foil, and a thermally conductive adhesive sheet or thermally conductive coating layer stacked on a bottom surface of the base material.

11. The thermally conductive member of claim 6, wherein the thermally conductive element comes into direct contact with a surface of the heating source, and the support comes into direct contact with a surface of the cooling unit.

12. The thermally conductive member of claim 6, wherein the thermally conductive element comes into contact with an inner wall of the accommodation space of the body when accommodating or comes into contact with the inner wall of the accommodation space due to the spreading.

13. The thermally conductive member of claim 6, wherein thermal conductivity of the thermally conductive element is higher than thermal conductivity of the body.

14. The thermally conductive member of claim 6, wherein the thermally conductive element comprises self adhesion due to the viscosity, and
wherein due to the self adhesion, the thermally conductive element and the support are not separated from each other when an externally applied force is not present.

15. The thermally conductive member of claim 6, wherein an uneven part extending along an inner wall of the accommodation space of the body in a thickness direction is formed.
